Europäisches Patentamt

European Patent Office

Office européen des brevets

(11) Publication number: **0 517 039 A1**

# EUROPEAN PATENT APPLICATION

(21) Application number: **92108562.7**

(22) Date of filing: **21.05.92**

(51) Int. Cl.⁵: **H01L 41/18**, H01L 41/22

(30) Priority: **05.06.91 US 710680**

(43) Date of publication of application:
**09.12.92 Bulletin 92/50**

(84) Designated Contracting States:
**DE FR GB IT**

(71) Applicant: **ACOUSTIC IMAGING TECHNOLOGIES CORPORATION**
**10027 South 51st Street**
**Phoenix, Arizona 85044(US)**

(72) Inventor: **Slayton, Michael Henry**
**1335 E. Louis Way**
**Tempe Arizona 85284(US)**

(74) Representative: **Kasseckert, Rainer**
**DORNIER GMBH Kleeweg 3**
**W-7990 Friedrichshafen 1(DE)**

(54) Piezoelectric ceramic-epoxy composite and method of making same.

(57) A piezoelectric ceramic-epoxy composite comprising particles predominantly 1/2 $\lambda$ (half wavelength) in thickness of piezoelectric ceramic and epoxy also disclosed is a method of making a piezoelectric ceramic-epoxy composite. The method comprises mixing ceramic powder with a particle size in the range of about 3/4 $\lambda$ to 1-1/2 $\lambda$ and, preferably, predominantly larger than 1/2 $\lambda$ average particle size with non-polymerized epoxy in the proportion of 20% to 65% ceramic powder, by volume and spreading the ceramic-epoxy mixture on a flat substrate to a thickness of approximately the size of the powder particles. The mixture is then evacuated to remove air bubbles and the epoxy is cured to produce a sheet of ceramic and epoxy. The sheet is surface ground to 1/2 $\lambda$ (half wavelength) of a predetermined resonant frequency.

EP 0 517 039 A1

## Background of the Invention

Piezoelectric epoxy composites have been investigated for a variety of applications from underwater acoustic usage to high frequency medical imaging. A variety of approaches to making piezoelectric composite materials have been suggested and various types of piezocomposites has been described.

It is well known that piezocomposites address several problems associated with solid piezoelectric materials: high specific acoustic impedance (approximately 30 Mrayl), and lower electro-mechanical coupling constant, kt. Coupling of the thickness mode to the spurious lateral modes are among the most serious problems. While successfully solving the problems listed above, the piezocomposites are certainly creating additional problems; e.g., non-trivial processes of fabrication along with electrically excited Lamb wave resonances in lateral directions associated with the regular structure of piezocomposites.

The present invention involves an approach to the fabrication technique of piezoelectric - polymer composites to reduce the problems mentioned above.

## Summary of the Invention

According to the invention there is provided a novel piezoelectric ceramic and epoxy composite and a method of making such a composite.

The composite comprises a piezoelectric ceramic-epoxy comprising ceramic particles predominantly $1/2\ \lambda$ (half wavelength) in thickness and epoxy.

The composite is made by a method comprising: providing a piezoelectric ceramic powder with a particle size in the range of about $3/4\ \lambda$ to $1\text{-}1/2\ \lambda$ and, preferably, predominantly larger than $1/2\ \lambda$ average particle size; mixing the piezoelectric ceramic powder with non-polymerized epoxy in the proportion of 20% to 65% ceramic powder, by volume; spreading the ceramic-epoxy mixture on a flat substrate to a thickness of approximately the size of the powder particles; evacuating the mixture to remove air bubbles and curing the epoxy to produce a sheet of ceramic and epoxy. Thereafter the sheet is surface ground to $1/2\ \lambda$ (half wavelength) of a predetermined resonant frequency.

Desirably, for practical purposes, the sheet of piezoelectric ceramic epoxy composite is metalized on opposite surfaces and polarized for end use applications.

## Detailed Description of the Preferred Embodiments

### Single Layer Piezocomposite

Desirably, for the ease of fabrication of piezoelectric ceramic powder with narrow particle size distribution, approximately 95% of the material within ± 5 micron tolerance range is used. The particle size is chosen to be larger than $1/2\ \lambda$ (half wavelength) of a desirable resonant frequency. Suitable piezoelectric ceramic materials are, for example, lead zirconate titanate, lead meta niobate, and modified lead titanate.

The powder of fired piezoelectric ceramic is laminated with epoxy to form a sheet of the composite. After the epoxy is polymerized, (i.e., cured) the sheet is surface ground to a thickness dimension of $1/2\ \lambda$ of a desirable resonant frequency. The resultant sheet of piezoelectric material is then metallized, polarized and formed to a desirable shape.

### Process Discussion

It is preferred that the particle size distribution should be as narrow as practically possible - 90% of the powder distributed within 10% range seems to be achievable with standard equipment and sieves. It is also preferable that the initial particle size be kept within $3/4\ \lambda$ to $1\text{-}1/2\ \lambda$ of a desirable resonance frequency. Larger particle size may lead to the increase of specific acoustic impedance and unwanted resonances.

Several epoxies have been employed for the process, such as Hysol, Eccogel, Stycast or combinations thereof. The volume percentage range of PZT ceramic should be between 20% and 65%. The best results from practical and acoustic standpoint seem to be achieved with approximately 30% to 65% and, specifically, 40% volume fraction of ceramic powder. The mixture of epoxy and ceramic is stirred well and mixed, for example, for 10 minutes. The epoxy may be air cured or cured by heating.

After spreading the ceramic-epoxy mixture on a flat substrate, such as a teflon coated sheet to which the epoxy will not adhere, the thickness of the spread mixture may be controlled, such as by either putting another flat surface on top of the spread or with a straight edge.

Metallizing of opposite surfaces of the cured sheet may be accomplished by many well known methods such as vacuum deposition or electroless plating. Metallized composites can be cut into designated shapes, e.g., round, square, etc., and subjected to a polarization by applying a DC voltage with a potential of at least 50V per 0.001 inches. The piezoelectric ceramic-epoxy composite demonstrated activity co-efficient $d_{33}$ of at least 75 at resonant frequency of 3.5 MHz and 7.5 MHz.

Polarization of the piezocomposite is advantageously done in the range of 2MV/m to 3MV/m depending upon the thickness of the composite sheet. A piezocomposite of "4-5 particle thick layer" for a comparison to a single layer "1-2 particles thick" was used to establish a reference point for the process.

## Examples

Two examples of cross-sectioned piezocomposites were examined at magnification of X 150 ('single layer composite') and ('multi-layer composite'). In both cases, the ceramic fractional volume was held at approximately 40%. Polarization of both samples was done at 2.9 MV/m under similar conditions.

It appears that both samples have specific gravity D and dielectric constant $E^S$ close to each other, with somewhat different longitudinal acoustic velocity $V^D$ andconsiderable difference in piezoelectric strain constant $d_{33}$ (see Table I).

Attempts were made to optimize the single layer piezocomposite by varying the epoxy material and ceramic-epoxy volume ratio (range from 25% to 65% ceramic volume). It was found that optimum ration for this composite is approximately 40% PZT-5A powder used with medium-soft epoxy. The results shown in Table II were measured and calculated for the optimized samples.

Resonance curves measured with HP Network Analyzer for the single layer piezocomposite samples resonating 1.03MHz and 5.45MHz thickness mode show small amplitude of spurious resonances and broad bandwidth regions.

TABLE I

|  | Single Layer | Multi-Layer |
|---|---|---|
| Specific Gravity D($Kg/m^3$) | 4.78 | 4.81 |
| Dielectric Constant $E^S$ | 226 | 196 |
| Longitudinal Acoustic Velocity $V^D$[M/sec.]x10 | 2.34 | 2.10 |
| Piezoelectric Strain Constant* $d_{33}$[P c/N] | 75 approx. | 22 approx. |

*Measured with Berlincourt $d_{33}$-meter.

The above results show that the level of piezoelectric activity in a "single layer" piezocomposite is considerably higher than in "multi-layer" composite.

## TABLE II

| | |
|---|---|
| Specific Gravity D [Kg/m3] | 4.71 |
| Dielectric Constant $E^S$ | 230 |
| Longitudinal Acoustic Velocity $V^D$ [M/sec.]x10$^3$ | 2.10 |
| Specific Acoustic Impedance Z [Mrayl] | 9.90 |
| Piezoelectric Strain Constant [pC/N] | 75 |
| *Coupling Factor Kt [%] | .61 |
| *Mechanical Qm | 9.1 |

*Both Kt and Qm were calculated using resonance and antiresonance frequency method.

From analysis of the foregoing, it appears that optimized piezocomposite shows low acoustic impedance (Z-9.9 Mrayl) and low Qm = 9.1 with high electro-mechanical coupling factor kt = .61 (which correlates closely with other composites. Apparently, due to the irregular mechanical structure of the piezocomposite, spurious resonance modes are suppressed in the radial direction.

It is apparent from the foregoing that various changes and modifications may be made without departing from the invention. Accordingly, the scope of the invention should be limited only by the appended claims wherein what is claimed is:

**Claims**

1. A piezoelectric ceramic-epoxy composite comprising particles predominantly 1/2 $\lambda$ (half wavelength) in thickness of piezoelectric ceramic and epoxy.

2. A piezoelectric ceramic-epoxy composite according to claim 1 having piezoelectric activity coefficient $d_{33}$ of at least 75 at the resonant frequency of 3.5 MHz and 7.5 MHz.

3. A method of making a piezoelectric ceramic-epoxy composite comprising:
   providing piezoelectric ceramic powder with a particle size in the range of about 3/4 $\lambda$ to 1-1/2 $\lambda$ and, preferably, predominantly larger than 1/2 $\lambda$ average particle size;
   mixing said piezoelectric ceramic powder with non-polymerized epoxy in the proportion of 20% to 65% ceramic powder, by volume;
   spreading said ceramic-epoxy mixture on a flat substrate to a thickness of approximately the size of the powder particles;
   evacuating the mixture to remove air bubbles and curing the epoxy to produce a sheet of ceramic and epoxy; and
   surface grinding the ceramic-epoxy sheet to 1/2 $\lambda$ (half wavelength) of a predetermined resonant frequency.

4. A method according to claim 3 further comprising metallizing opposite surfaces of the ceramic-epoxy sheet and polarizing the metalized sheet.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | EP-A-0 219 555 (SUMITOMO) <br> * column 5, line 15 - column 8, line 49; figures 1-3 * <br> --- | 1-4 | H01L41/18 <br> H01L41/22 |
| A | PATENT ABSTRACTS OF JAPAN <br> vol. 11, no. 138 (E-503)2 May 1987 <br> & JP-A-61 278 300 ( NGK SPARK PLUG ) 9 December 1986 <br> * abstract * <br> --- | 1-4 | |
| A | SENSORS AND ACTUATORS. <br> vol. 14, no. 4, August 1988, LAUSANNE CH <br> pages 361 - 368; <br> A.M.VARAPRASAD ET AL.: 'PZT-polymer composites for transducers of hydrophone systems' <br> * the whole document * <br> ----- | 1-4 | |

TECHNICAL FIELDS SEARCHED (Int. Cl.5 )

H01L

The present search report has been drawn up for all claims

| Place of search | Date of completion of the search | Examiner |
|---|---|---|
| BERLIN | 09 SEPTEMBER 1992 | MUNNIX S. |

EPO FORM 1503 03.82 (P0401)